(19) **Europäisches Patentamt / European Patent Office / Office européen des brevets**

(11) **EP 4 526 994 B1**

(12) **FASCICULE DE BREVET EUROPEEN**

(45) Date de publication et mention de la délivrance du brevet:
**08.04.2026 Bulletin 2026/15**

(21) Numéro de dépôt: **23725260.6**

(22) Date de dépôt: **16.05.2023**

(51) Classification Internationale des Brevets (IPC):
**H03F 1/32** *(2006.01)* **H03F 3/195** *(2006.01)*
**H03F 3/24** *(2006.01)*

(52) Classification Coopérative des Brevets (CPC):
**H03F 1/3247; H03F 1/3258; H03F 3/195; H03F 3/245**

(86) Numéro de dépôt international:
**PCT/EP2023/063057**

(87) Numéro de publication internationale:
**WO 2023/222655 (23.11.2023 Gazette 2023/47)**

(54) **PROCEDE DE PRE-DISTORSION D'UN SIGNAL D'ENTREE POUR COMPENSER L'EFFET D'UNE FONCTION DE TRANSFERT NON-LINEAIRE D'UN AMPLIFICATEUR DE PUISSANCE, PRODUIT PROGRAMME D'ORDINATEUR ET DISPOSITIF CORRESPONDANTS**

VERFAHREN ZUR VORVERZERRUNG EINES EINGANGSSIGNALS UM DIE WIRKUNG EINER NICHTLINEAREN ÜBERTRAGUNGSFUNKTION EINES LEISTUNGSVERSTÄRKERS ZU KOMPENSIEREN, ENTSPRECHENDES COMPUTERPROGRAMMPRODUKT UND ENTSPRECHENDE VORRICHTUNG

METHOD OF PRE-DISTORTING AN INPUT SIGNAL TO COMPENSATE FOR THE EFFECT OF A NON-LINEAR TRANSFER FUNCTION OF A POWER AMPLIFIER, CORRESPONDING COMPUTER PROGRAM PRODUCT AND DEVICE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **19.05.2022 FR 2204803**

(43) Date de publication de la demande:
**26.03.2025 Bulletin 2025/13**

(73) Titulaires:
- **UNIVERSITE DE BORDEAUX**
  **33000 Bordeaux (FR)**
- **Institut Polytechnique de Bordeaux**
  **33402 Talence Cedex (FR)**
- **Centre National de la Recherche Scientifique**
  **75016 Paris Cedex 16 (FR)**

(72) Inventeurs:
- **RIVET, François**
  **33400 TALENCE (FR)**
- **DEVAL, Yann**
  **33800 BORDEAUX (FR)**

- **LAPUYADE, Hervé**
  **33850 LEOGNAN (FR)**
- **KERHERVE, Eric**
  **33600 PESSAC (FR)**
- **DELTIMPLE, Nathalie**
  **33600 PESSAC (FR)**
- **FELLMANN, Maxandre**
  **33400 TALENCE (FR)**

(74) Mandataire: **Santarelli**
**Tour Trinity**
**1 bis Place de la Défense**
**92400 Courbevoie (FR)**

(56) Documents cités:
**US-B1- 10 075 201**

- GUAN NING ET AL: "Model Identification for Digital Predistortion of Power Amplifier With Signed Regressor Algorithm", IEEE MICROWAVE AND WIRELESS COMPONENTS LETTERS, IEEE SERVICE CENTER, NEW YORK, NY, US, vol. 28, no. 10, 1 October 2018 (2018-10-01), pages 921 - 923, XP011691013, ISSN: 1531-1309, [retrieved on 20181004], DOI: 10.1109/LMWC.2018.2860790
- YEH HEN-GEUL ET AL: "Hadamard SCFDMA-A modified uplink transmission scheme with low PAPR and SER", 2015 ANNUAL IEEE SYSTEMS CONFERENCE (SYSCON) PROCEEDINGS, IEEE, 13 April 2015 (2015-04-13), pages 711 - 715, XP032782405, DOI: 10.1109/SYSCON.2015.7116834
- KATZ ALLEN ET AL: "The Evolution of PA Linearization: From Classic Feedforward and Feedback Through Analog and Digital Predistortion", IEEE MICROWAVE MAGAZINE, IEEESERVICE CENTER, PISCATAWAY, NJ, US, vol. 17, no. 2, 1 February 2016 (2016-02-01), pages 32 - 40, XP011591943, ISSN: 1527-3342, [retrieved on 20160112], DOI: 10.1109/MMM.2015.2498079

**Description**

**Domaine de l'invention**

Le domaine de l'invention est celui de la transmission de données via l'utilisation d'un signal radiofréquences.

L'invention se rapporte plus particulièrement à une méthode de pré-distorsion afin de compenser l'effet d'une fonction de transfert non-linéaire d'un amplificateur de puissance configuré pour amplifier un tel signal radiofréquences.

L'invention a ainsi des applications, notamment, mais non exclusivement, dans le domaine de la téléphonie mobile (e.g. réseaux 4G ou 5G tels que définis par le 3GPP (pour « 3rd Generation Partnership Project » en anglais)), des réseaux locaux sans fil WLAN (pour « Wireless Local Area Network » en anglais, e.g. utilisant le WiFi), les systèmes de radiodiffusion numérique (DVB-T (pour « Digital Video Broadcasting - Terrestrial » en anglais), ISDB-T (pour « Integrated Services Digital Broadcasting-Terrestrial » en anglais), DAB (pour « Digital Audio Broadcasting » en anglais)), l'accès internet sans fil à haut débit (WiMAX), les liaisons numériques asymétriques (xDSL), les liaisons point à point, etc.

**Art antérieur et ses inconvénients**

Les techniques de communications du type OFDM (pour « Orthogonal Frequency Division Multiplex » en anglais) ou WCDMA (pour « Wideband Code Division Multiple Access » en anglais) permettent d'augmenter considérablement l'efficacité spectrale des systèmes de communications numériques pour répondre à leur croissance exponentielle. Cependant, les formes d'ondes mises en œuvre dans le cadre de ces techniques ont un rapport puissance crête sur puissance moyenne, ou PAPR (pour « Peak-to-Average Power Ratio » en anglais) élevé. Il en résulte que ces formes d'ondes sont très sensibles aux non-linéarités introduites par les amplificateurs de puissance, ou PA (pour « Power Amplifier » en anglais). En particulier, de telles non-linéarités faussent l'amplitude et, le cas échéant, la phase du signal utile radiofréquences. Ceci conduit à la création d'interférences dans les canaux de communication adjacents et une dégradation de l'amplitude du vecteur d'erreur, ou EVM (pour « Error Vector Magnitude » en anglais).

Pour éviter ces problèmes, une possibilité est d'exploiter la zone d'amplification linéaire du PA. Cependant, l'efficacité énergétique de l'amplification dans la région linéaire chute considérablement par rapport à l'efficacité dans la région non linéaire lorsque le PA fonctionne proche de la puissance saturée.

Alternativement, la pré-distorsion numérique, ou DPD (pour « Digital PreDistortion » en anglais) consiste à compenser les distorsions induites par la fonction de transfert non-linéaire du PA afin de transmettre correctement les signaux modulés tout en prenant avantage de la haute efficacité énergétique de la région non-linéaire de la fonction de transfert du PA. Selon l'approche DPD, telle que décrite par exemple dans l'article de A. Katz, J. Wood, and D. Chokola, « The evolution of pa linearization: From classic feedforward and feedback through analog and digital predistortion, » IEEE Microwave Magazine, vol. 17, no. 2, pp. 32-40, 2016, un bloc de pré-distorsion (i.e. implémentant un modèle inverse de la fonction de transfert du PA) est implémenté dans le domaine digital en amont du PA au sein d'un émetteur afin que le système complet se comporte comme un système linéaire.

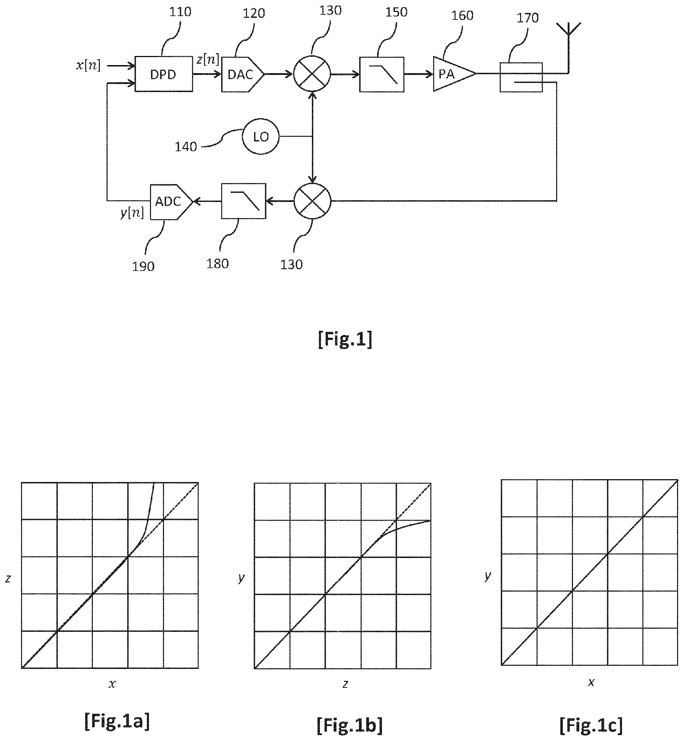

Par ailleurs, en raison des changements de comportement du PA au cours du temps (dérive des paramètres du PA en fonction e.g. de la température, du vieillissement), les paramètres du modèle implémenté dans le bloc de pré-distorsion doit être mise à jour dans le temps. La **[Fig.1]** illustre ainsi une architecture DPD typique. Les échantillons x[n] du signal d'entrée x, ici en bande de base, sont générés numériquement en fonction du standard de communication utilisé (débit, encodage, schéma de modulation...).

Plus particulièrement, les échantillons x[n] sont traités par le bloc 110 de pré-distorsion délivrant des échantillons pré-distordus z[n] qui sont convertis en un signal analogique par un DAC 120 (pour « Digital to Analogue Converter » en anglais). Le signal analogique est transposé en radiofréquences par un mélangeur 130 alimenté par un oscillateur local 140. Le signal radiofréquences est filtré par un filtre 150 pour supprimer son image. Le signal obtenu est ensuite amplifié par le PA 160 avant rayonnement par l'antenne. Par ailleurs, afin de tracker les changements de comportement du PA 160 au cours du temps, un coupleur 170 est ajouté en sortie du PA 160 pour extraire un signal représentatif du signal radiofréquences tel qu'amplifié par le PA 160. Ce signal représentatif est transposé en basses fréquences par un mélangeur 130 également alimenté par l'oscillateur local 140. Le signal ainsi transposé est filtré par un filtre 180 anti-repliements avant échantillonnage par un ADC 180 (pour « Analogue to Digital Converter » en anglais). L'ADC 180 délivre ainsi les échantillons $y[n]$ utilisés par le bloc 110 de pré-distorsion afin de mettre à jour son modèle. Plus particulièrement, le modèle implémenté dans le bloc 110 de pré-distorsion est calculé afin que les remontées spectrales ajoutées sur les échantillons pré-distordus $z[n]$ compensent celles liées à la non-linéarité du PA 160. En pratique, la fonction de transfert du bloc 110 de pré-distorsion applique une préaccentuation des niveaux les plus élevés des échantillons $x[n]$ **([Fig.1a])** de sorte à compenser la saturation de la fonction de transfert du PA 160 **([Fig.1b])**. Lorsque la fonction de transfert du bloc 110 de pré-distorsion correspond à celle du PA 160, le système global présente une fonction de transfert linéarisée **([Fig.1c])**.

Par ailleurs, les techniques de DPD sont classiquement classées en trois catégories suivant le plan de fréquences considéré :

- Pré-distorsion en bande de base ;
- Pré-distorsion en fréquence intermédiaire ; et
- Pré-distorsion en radiofréquences.

La technique la plus largement adoptée est la pré-distorsion en bande de base qui fonctionne à la fréquence d'échantillonnage la plus basse par rapport aux deux autres techniques précitées. Il peut ainsi être envisagé d'implémenter une pré-distorsion selon une méthode connue en bande de base sur un DSP (pour « Digital Signal Processor » en anglais) ou un FPGA (pour « Field-programmable gate array » en anglais). Cependant, le coût en ressources numériques de telles méthodes connues rend difficilement envisageable une implémentation en fréquence intermédiaire ou en radiofréquences. Par ailleurs, la recherche du modèle à implémenter dans le bloc 110 de pré-distorsion met en œuvre un algorithme itératif qui a une complexité de calcul importante.

Le brevet US 10,075,201 B1 divulgue un contrôleur adaptatif pour un système non linéaire comprenant un filtre de Volterra dont la fonction de transfert est définie par P coefficients. Le contrôleur comprend également un circuit d'alignement et de compensation, qui permet d'aligner les échantillons d'entrée sur les échantillons de sortie du système non linéaire. Le contrôleur génère une matrice $P \times P$ à partir d'au moins un échantillon d'entrée ou de sortie du système non linéaire, puis normalise chaque élément de la matrice $P \times P$ à l'aide d'un facteur de normalisation respectif. Le contrôleur génère ensuite un système de P équations linéaires à partir de la matrice $P \times P$ et d'une matrice $P \times 1$ dérivée des échantillons d'entrée et de sortie du système non linéaire, en utilisant la décomposition de Cholesky. Le contrôleur multiplie enfin chacune des valeurs obtenues en résolvant le système de P équations linéaires par l'inverse d'un facteur de normalisation respectif afin de générer les coefficients pour le filtre de Volterra.

Il existe ainsi un besoin pour une technique de pré-distorsion présentant une charge de calcul réduite par rapport aux techniques connues, permettant par exemple une implémentation aussi bien en bande de base qu'en fréquence intermédiaire ou même directement en radiofréquences.

**Exposé de l'invention**

Dans un mode de réalisation de l'invention, il est proposé un procédé de pré-distorsion d'un signal d'entrée pour compenser l'effet, sur un signal radiofréquences généré à partir du signal d'entrée, d'une fonction de transfert non-linéaire d'un amplificateur de puissance configuré pour amplifier le signal radiofréquences. Selon un tel procédé, un dispositif électronique effectue :

- une transformation de Walsh d'au moins une série de M termes fonction d'au moins une série de M échantillons temporels du signal d'entrée délivrant M composantes séquentielles d'au moins une série transformée correspondante ;
- pour au moins une composante séquentielle donnée du domaine de Walsh, un calcul d'au moins une somme d'une pluralité d'opérandes résultant du produit entre, d'une part, une donnée fonction d'au moins un élément, correspondant à la composante séquentielle donnée, d'une série transformée et, d'autre part, un coefficient de pré-distorsion correspondant délivrant une composante séquentielle d'un signal d'entrée transformé pré-distordu. Au moins une donnée est fonction d'au moins une convolution dyadique entre deux éléments, correspondant à la composante séquentielle donnée, appartenant chacun à une série transformée et/ou étant fonction d'au moins une auto-convolution dyadique d'un élément, correspondant à la composante séquentielle donnée, d'une série transformée. La somme suit une structure d'une série de Volterra, fonction d'échantillons temporels du signal d'entrée, transposée dans le domaine de Walsh. Les coefficients de pré-distorsion sont déterminés afin de compenser l'effet de la fonction de transfert de l'amplificateur de puissance. Ledit calcul répété pour les M composantes séquentielles du domaine de Walsh délivrant M composantes séquentielles du signal d'entrée transformé pré-distordu,
- une transformation de Walsh inverse des M composantes séquentielles du signal d'entrée transformé pré-distordu délivrant un signal de sortie pour la génération du signal radiofréquences.

Ainsi, l'invention propose une solution nouvelle et inventive pour compenser l'effet de la fonction de transfert non-linéaire de l'amplificateur de puissance.

Plus particulièrement, il est proposé ici d'implémenter le modèle de pré-distorsion dans le domaine de Walsh. En effet, la structure binaire des séquences de Walsh et la structure des calculs numériques qui en résultent dans le domaine de Walsh permettent de réduire la charge de calcul par rapport aux techniques connues. Notamment, une telle approche permet une implémentation aussi bien en bande de base qu'en fréquence intermédiaire ou même directement en radiofréquences du modèle de pré-distorsion.

Un tel modèle est plus particulièrement basé sur l'évaluation de sommes correspondant chacune à une composante séquentielle d'une série de Volterra transposée dans le domaine de Walsh. Dans certains modes de réalisation, la transformation de Walsh est appliquée à une pluralité de séries de M termes fonction d'au moins une série de M échantillons temporels du signal d'entrée délivrant M composantes séquentielles d'une pluralité de séries transformées correspondantes. Ladite au moins une donnée est fonction :

- d'au moins une convolution dyadique entre deux éléments, correspondant à la composante séquentielle donnée, appartenant chacun à une série transformée de la pluralité de séries transformées ; et/ou
- d'au moins une auto-convolution dyadique d'un élément, correspondant à la composante séquentielle donnée, d'une série transformée de la pluralité de séries transformées.

La somme suit une structure d'une série de Volterra, fonction de la pluralité de séries de M échantillons temporels du signal d'entrée, transposée dans le domaine de Walsh.

Dans certains modes de réalisation, au moins une série de M termes comprend au moins un terme fonction :

- du produit entre deux échantillons temporels du signal d'entrée ; et/ou
- d'au moins un échantillon temporel du signal d'entrée élevé à une puissance entière.

Ainsi, tout ou partie des multiplications des échantillons du signal d'entrée sont implémentées dans le domaine temporel.

Dans certains modes de réalisation, la transformation de Walsh est appliquée à une pluralité de séries de M termes fonction d'une série de M échantillons temporels du signal d'entrée délivrant M composantes séquentielles d'une pluralité de séries transformées correspondantes. Ladite au moins une donnée est fonction d'au moins une auto-convolution dyadique d'un élément, correspondant à la composante séquentielle donnée, d'une série transformée de la pluralité de séries transformées.

Dans certains modes de réalisation, au moins une série de M termes comprend au moins un terme fonction d'au moins un échantillon temporel du signal d'entrée élevé à une puissance entière.

Dans certains modes de réalisation, la transformation de Walsh est appliquée à une série de M termes correspondant à une série donnée de M échantillons temporels du signal d'entrée délivrant M composantes séquentielles d'une série transformée correspondante. Ledit calcul comprend le calcul d'une somme de M opérandes, le i-ème opérande, i un entier de 1 à M, résultant du produit entre, d'une part, une donnée résultant d'une auto-convolution dyadique d'ordre i d'un élément, correspondant à la composante séquentielle donnée, de la série transformée et, d'autre part, le coefficient de pré-distorsion correspondant.

Ainsi, le modèle de pré-distorsion est basé sur une série de Volterra réduite à un modèle dit MP (pour « Memory Polynomial » en anglais).

Dans certains modes de réalisation, le procédé comprend une détermination des coefficients de pré-distorsion sur la base d'une minimisation d'un signal d'erreur représentatif d'un écart entre, d'une part, le signal d'entrée et, d'autre part, un signal représentatif d'une modulation du signal radiofréquences amplifié.

Dans certains modes de réalisation, le procédé comprend une détermination des coefficients de pré-distorsion sur la base d'une minimisation d'un signal d'erreur représentatif d'un écart entre, d'une part, le signal d'entrée et, d'autre part, un deuxième signal de sortie généré par application dudit procédé de pré-distorsion à un signal d'entrée représentatif d'une modulation du signal radiofréquences amplifié.

Ainsi, les coefficients du modèle de pré-distorsion sont déterminés directement.

Dans certains modes de réalisation, le procédé comprend une détermination des coefficients de pré-distorsion sur la base d'une minimisation d'un signal d'erreur représentatif d'un écart entre, d'une part, un signal représentatif d'une modulation d'un deuxième signal radiofréquences généré à partir dudit signal d'entrée non pré-distordu et amplifié par l'amplificateur de puissance et, d'autre part, ledit signal de sortie.

Ainsi, les coefficients du modèle sont tout d'abord déterminés afin de modéliser l'amplificateur de puissance. Les coefficients de pré-distorsion sont ainsi déterminés à partir des coefficients modélisant l'amplificateur de puissance (e.g. par inversion d'une matrice comprenant les coefficients modélisant l'amplificateur de puissance).

Dans certains modes de réalisation, ladite détermination met en œuvre, pour ladite minimisation, une technique appartenant au groupe comprenant :

- Moindres carrés ;
- Moindres carrés normalisés ;
- Algorithme de Gauss-Newton ; ou
- Moindres carrés récursifs.

Dans certains modes de réalisation, ladite technique est implémentée dans le domaine de Walsh sur la base des signaux constituant le signal d'erreur transposés dans le domaine de Walsh.

Ainsi, la charge de calcul est réduite pour la détermination des coefficients de pré-distorsion. Dans certains modes de réalisation, ladite détermination est effectuée périodiquement.

Ainsi, les variations des caractéristiques de l'amplificateur de puissance (e.g. en températures ou en vieillissement) sont prises en compte dans le modèle.

L'invention concerne également un programme d'ordinateur comprenant des instructions de code de programme pour la mise en œuvre d'un procédé de pré-distorsion tel que décrit précédemment, selon l'un quelconque de ses différents modes de réalisation, lorsqu'il est exécuté sur un ordinateur.

Dans un mode de réalisation de l'invention, il est proposé un dispositif électronique de pré-distorsion comprenant une machine de calcul reprogrammable ou une machine de calcul dédiée configurée pour mettre en œuvre les étapes du procédé de pré-distorsion selon l'invention (selon l'un quelconque des différents modes de réalisation précités). Ainsi, les caractéristiques et avantages de ce dispositif sont les mêmes que ceux des étapes correspondantes du procédé de pré-distorsion décrit précédemment. Par conséquent, ils ne sont pas détaillés plus amplement. L'invention concerne également un émetteur radiofréquences comprenant un dispositif électronique de pré-distorsion tel que décrit précédemment (selon l'un quelconque des différents modes de réalisation précités).

**Liste des figures**

D'autres buts, caractéristiques et avantages de l'invention apparaîtront plus clairement à la lecture de la description suivante, donnée à titre de simple exemple illustratif, et non limitatif, en relation avec les figures, parmi lesquelles :

**[Fig.1],** discutée ci-dessus dans la section « Art antérieur et ses inconvénients », représente un émetteur radiofréquences implémentant un bloc de pré-distorsion numérique selon une technique connue ;

**[Fig.1a],** discutée ci-dessus dans la section « Art antérieur et ses inconvénients », illustre la fonction de transfert du bloc de pré-distorsion numérique de la [Fig.1] ;

**[Fig.1b],** discutée ci-dessus dans la section « Art antérieur et ses inconvénients », illustre la fonction de transfert du PA de la [Fig.1] ;

**[Fig.1c],** discutée ci-dessus dans la section « Art antérieur et ses inconvénients », illustre la fonction de transfert globale correspondant à la composition des fonctions de transferts du bloc de pré-distorsion numérique et du PA de la [Fig.1] ;

**[Fig.2]** illustre un émetteur radiofréquences implémentant un bloc de pré-distorsion numérique selon un mode de réalisation de l'invention ;

**[Fig.3]** représente les étapes d'un procédé de pré-distorsion selon un mode de réalisation de l'invention ;

**[Fig.4]** représente un exemple de structure de dispositif permettant la mise en œuvre de certaines étapes du procédé de pré-distorsion de la [Fig.3] selon un mode de réalisation de l'invention.

**Description détaillée de modes de réalisation de l'invention**

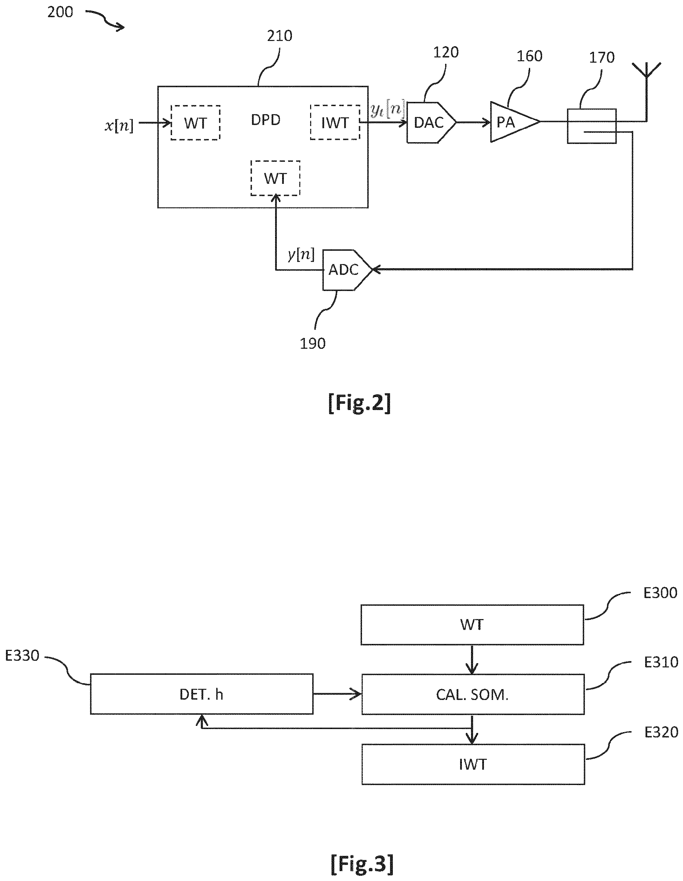

On présente désormais, en relation avec la **[Fig.2],** un émetteur 200 radiofréquences implémentant un bloc 210 de pré-distorsion numérique selon un mode de réalisation de l'invention.

Par rapport à l'architecture connue présentée ci-dessus en relation avec la [Fig.1], l'émetteur 100 comprend un bloc 210 de pré-distorsion implémentant le procédé de pré-distorsion décrit plus en détails ci-dessous en relation avec la [Fig.3]. Un tel procédé repose sur l'implémentation d'un modèle de pré-distorsion numérique basé sur la mise en œuvre d'une série de Volterra implémentée dans le domaine de Walsh. Plus particulièrement, la structure binaire des séquences de Walsh et la structure des calculs numériques qui en résultent dans le domaine de Walsh permettent de réduire la charge de calcul par rapport aux techniques connues.

Notamment, une telle approche permet une implémentation aussi bien en bande de base qu'en fréquence intermédiaire ou même directement en radiofréquences du modèle de pré-distorsion. C'est pourquoi, selon le mode de réalisation de la [Fig.2], le bloc 210 de pré-distorsion traite directement le signal radiofréquences tel qu'il doit être amplifié par le PA 160 avant rayonnement par l'antenne.

Cependant, dans d'autres modes de réalisation, le bloc 210 de pré-distorsion traite un signal d'entrée en bande de base ou en fréquence intermédiaire. Dans ce cas, le signal de sortie délivré par le bloc 210 de pré-distorsion est par exemple transposé en radiofréquences suivant une architecture du type de celle de la [Fig.1], e.g. via un mélangeur 130 alimenté par un oscillateur local 140. Dans ce cas, un mélangeur 130 également alimenté par l'oscillateur local 140 peut être utilisé sur la boucle de retour afin de générer le signal utilisé par le bloc 210 de pré-distorsion dans le but de mettre à jour son modèle.

Dans d'autres modes de réalisation, il est tiré parti de la nature binaire des séquences de Walsh afin d'implémenter la transformée de Walsh inverse de manière semi-analogique. Plus particulièrement, chaque composante séquentielle $Y_{t,n}$ du signal de sortie pré-distordu $y_t[n]$ est convertie en analogique via un DAC 1-bit (e.g. du type buffer) contrôlé en amplitude par la séquence de Walsh inverse correspondant à la composante séquentielle considérée. Les différentes sorties des DAC 1-bit sont sommées entre elles dans le domaine analogique afin d'obtenir la version à temps continu du signal de sortie $y_t[n]$.

On présente désormais, en relation avec la **[Fig.3],** les étapes d'un procédé de pré-distorsion selon un mode de réalisation de l'invention.

### 1. Etape E300 :

Lors d'une **étape E300,** une transformation de Walsh est appliquée à au moins une série de M termes fonction d'au moins une série de M échantillons temporels x[n] du signal d'entrée délivrant M composantes séquentielles d'au moins une série transformée correspondante.

### 1.1 Cas général :

Plus particulièrement, le modèle de pré-distorsion considéré ici est basé sur une série de Volterra transposée dans le domaine de Walsh. Il est à noter qu'un tel modèle s'applique aussi bien à la modélisation de la fonction de transfert du PA 160, qu'à la pré-distorsion en tant que telle du signal d'entrée $x[n]$. Seuls les coefficients mis en jeu dans les deux cas changent comme décrit plus avant ci-dessous en relation avec l'étape E330. De retour à l'étape E300, on considère la formulation suivante d'une série de Volterra dans le domaine temporel :

[Math.1]

$$y_t[n] = \sum_{q=1}^{Q} y_t^{(q)}[n]$$

où $y_t[n]$ est l'échantillon d'indice n en sortie du bloc 210, et où :

[Math.2]

$$y_t^{(q)}[n] = \sum_{m_1=0}^{M-1} \sum_{m_2=0}^{M-1} ... \sum_{m_q=0}^{M-1} h^{(q)}(m_1, m_2, ... m_q)$$
$$.x[n - m_1]x[n - m_2]...x[n - m_q]$$

avec :

- $h^{(q)}(m_1, m_2, ..., m_q)$ les noyaux de Volterra ; et
- $x[n - m_1]x[n - m_2]...x[n - m_q]$ les formes d'onde de Volterra.

Afin de pouvoir appliquer une transformation de Walsh discrète, on segmente les formes d'ondes de Volterra en séries constituées de M formes d'ondes, ici organisées sous forme de vecteurs. On obtient ainsi, pour les formes d'ondes linéaires, les vecteurs suivants :

[Math.3]

$$\mathbf{x}_{0,n} = \begin{bmatrix} x[nM] \\ x[nM - 1] \\ \vdots \\ x[nM - M + 1] \end{bmatrix} \quad \cdots \quad \mathbf{x}_{m_1,n} = \begin{bmatrix} x[nM - m_1] \\ x[nM - 1 - m_1] \\ \vdots \\ x[nM - M + 1 - m_1] \end{bmatrix}$$

pour les formes d'ondes quadratiques :

[Math.4]

$$\mathbf{x}_{00,n} = \begin{bmatrix} x^2[nM] \\ x^2[nM-1] \\ \vdots \\ x^2[nM-M+1] \end{bmatrix} \cdots \mathbf{x}_{m_1 m_2,n} = \begin{bmatrix} x[nM-m_1]x[nM-m_2] \\ x[nM-1-m_1]x[nM-1-m_2] \\ \vdots \\ x[nM-M+1-m_1]x[nM-M+1-m_2] \end{bmatrix}$$

et de manière générale pour les formes d'ondes d'ordre $q$ :

[Math.5]

$$\mathbf{x}_{m_1 m_2 \cdots m_q,n} = \begin{bmatrix} x[nM-m_1]x[nM-m_2]\cdots x[nM-m_q] \\ x[nM-1-m_1]x[nM-1-m_2]\cdots x[nM-1-m_q] \\ \vdots \\ x[nM-M+1-m_1]x[nM-M+1-m_2]\cdots x[nM-M+1-m_q] \end{bmatrix}$$

Par application d'une transformée de Walsh discrète sur les séries précitées, on obtient ainsi les vecteurs :

[Math.6]

$$\mathbf{X}_{m_1 m_2 \cdots m_q,n} = \mathbf{W_L x}_{m_1 m_2 \cdots m_q,n} = \begin{bmatrix} X_{m_1 m_2 \cdots m_q,n}[1] \\ X_{m_1 m_2 \cdots m_q,n}[2] \\ \vdots \\ X_{m_1 m_2 \cdots m_q,n}[M] \end{bmatrix}$$

avec $W_L$ la matrice de Walsh d'ordre M (telle que définie par exemple dans l'article de J. Johnson and M. Puschel, "In search of the optimal walsh-hadamard transform," in 2000 IEEE International Conference on Acoustics, Speech, and Signal Processing. Proceedings (Cat. No.00CH37100), vol. 6, 2000, pp. 3347-3350 vol.6).

En adoptant une segmentation équivalente pour les noyaux de Volterra, on obtient après transformée de Walsh discrète de dimension M les vecteurs :

[Math.7]

$$\mathbf{H}_{m_1 m_2 \cdots m_q,n} = \mathbf{W_L h}_{m_1 m_2 \cdots m_q,n} = \begin{bmatrix} H_{m_1 m_2 \cdots m_q,n}[1] \\ H_{m_1 m_2 \cdots m_q,n}[2] \\ \vdots \\ H_{m_1 m_2 \cdots m_q,n}[M] \end{bmatrix}$$

Ainsi, la série de Volterra donnée par l'équation [Math.1] se transpose dans le domaine de Walsh, correspondant à une transformée de Walsh de dimension M, sous la forme :

[Math.8]

$$\mathbf{Y}_{t,n} = \sum_{q=1}^{Q} \sum_{m_1=0}^{M-1} \sum_{m_2=0}^{M-1} \cdots \sum_{m_q=0}^{M-1} \mathbf{X}_{m_1 m_2 \cdots m_q,n}.\mathbf{H}_{m_1 m_2 \cdots m_q,n}$$

avec $Y_{t,n}$ la valeur de la composante séquentielle d'indice $n$, $n$ un entier de 0 à M-1, dans le domaine de Walsh, du signal de sortie $y_t[n]$ du bloc 210.

**1.2 Cas MP :**

Afin de réduire plus avant la charge de calculs mis en œuvre dans le bloc 210 de pré-distorsion, un modèle à base de série de Volterra simplifié est mis en œuvre dans certains modes de réalisation. Parmi les modèles communément utilisés, il y a le modèle MP (pour « Memory Polynomial » en anglais). Dans ce cas, on a $m_1 = m_2 = ... = m_q = 0$ et l'équation [Math.8] se réduit à :

$$[\text{Math.9}]$$

$$\mathbf{Y}_{t,n} = \sum_{q=1}^{Q} \mathbf{X}_{q,n}.\mathbf{H}_{q,n}$$

avec :

$$[\text{Math.10}]$$

$$\mathbf{X}_{1,n} = \mathbf{W_L}\mathbf{x}_{1,n} \quad \cdots \quad \mathbf{X}_{Q,n} = \mathbf{W_L}\mathbf{x}_{Q,n}$$

où:

$$[\text{Math.11}]$$

$$\mathbf{x}_{1,n} = \begin{bmatrix} x[nM] \\ x[nM-1] \\ \vdots \\ x[nM-M+1] \end{bmatrix} \quad \cdots \quad \mathbf{x}_{Q,n} = \begin{bmatrix} x^Q[nM] \\ x^Q[nM-1] \\ \vdots \\ x^Q[nM-M+1] \end{bmatrix}$$

**1.3 Multiplication** vs. **convolution dyadique** :

Reconsidérant l'expression générale [Math.5] ou l'expression simplifiée du modèle MP [Math.11], on observe que la transformée de Walsh des formes d'ondes de Volterra de certains ordres implique la transformée de Walsh d'une (ou plusieurs) série dans laquelle un (ou plusieurs) terme et fonction :

- du produit entre deux échantillons temporels x[n] du signal d'entrée ; et/ou
- d'au moins un échantillon temporel $x$[n] du signal d'entrée élevé à une puissance entière.

Or, la transformée de Walsh d'un produit d'opérandes est égale à la convolution dyadique des transformées de Walsh desdits opérandes, comme rappelé e.g. dans l'article de M. Z. Anna Usakova, Jana Kotuliakova, « Journal of electrical engineering, » vol. 53, no. 9-10. Cambridge, LA: MIT Press, 1958, pp. 285-288. En d'autres termes :

$$[\text{Math.12}]$$

$$\mathbf{X}_{m_1m_2,n} = \mathbf{X}_{m_1,n} \circledast \mathbf{X}_{m_2,n}$$

où $\circledast$ représente la convolution dyadique. Une telle implémentation est très efficace en ce qui concerne la charge de calculs. En effet, la convolution dyadique de **x** et **y** s'exprime comme :

$$[\text{Math.13}]$$

$$\mathbf{z} = \mathbf{x} \circledast \mathbf{y} \quad z[n] = \frac{1}{P}\sum_{p=0}^{P} x(p)y(n \oplus p)$$

avec $p \oplus n$ la somme dyadique de p et $n$. Une telle somme dyadique s'exprime, lorsque $p$ et $n$ sont deux entiers positifs tels que :

[Math.14]

$$p = \sum_{i=0}^{\infty} p_i 2^i \quad n = \sum_{i=0}^{\infty} n_i 2^i$$

avec $p_i$, $n_i \in [0,1]$, comme l'expression :

[Math.15]

$$p \oplus n = \sum_{i=0}^{\infty} |p_i - n_i| 2^i$$

Ainsi, suivant les modes de réalisation considérés, la transformée de Walsh des formes d'ondes de Volterra de certains ordres met en oeuvre :

- au moins une convolution dyadique entre deux éléments, correspondant à une composante séquentielle donnée, correspondant à la transformée de Walsh de deux séries d'échantillons temporels x[n] du signal d'entrée ; et/ou
- au moins une auto-convolution dyadique d'un élément, correspondant à une composante séquentielle donnée, correspondant à la transformée de Walsh d'une série d'échantillons temporels x[n] du signal d'entrée.

### 1.4 Conclusion sur l'étape E300 :

Suivant les modes de réalisation décrits ci-dessus en relation avec l'étape E300, afin d'évaluer la transformée de Walsh des formes d'ondes de Volterra, les différentes configurations suivantes peuvent se présenter :

- une transformation de Walsh est appliquée à une pluralité de séries de M termes fonction d'une ou plusieurs série correspondantes de M échantillons temporels x[n] du signal d'entrée : il s'agit par exemple du cas général correspondant à l'équation [Math.5] lorsque tout ou partie des multiplications (ou élévations à la puissance, qui restent interprétées comme des calculs de multiplications) sont implémentées dans le domaine temporel avant transformée de Walsh des séries en question, les autres multiplications (ou élévations à la puissance qui restent interprétées comme des calculs de multiplications) étant implémentées dans le domaine de Walsh sous forme de convolutions dyadiques (ou auto-convolution dyadique le cas échéant) d'éléments de certaines séries transformées ;
- une transformation de Walsh est appliquée à une pluralité de séries de M termes fonction d'une seule série de M échantillons temporels $x$[n] du signal d'entrée : il s'agit par exemple du cas MP correspondant à l'équation [Math.11] et lorsque tout ou partie des élévations à la puissance (qui restent interprétées comme des calculs de multiplications) sont implémentées dans le domaine temporel avant transformée de Walsh des séries en question, les autres élévations à la puissance étant implémentées dans le domaine de Walsh sous forme d'auto-convolutions dyadiques d'éléments de certaines séries transformées ;
- une transformation de Walsh est appliquée à une seule série de M termes fonction d'une seule série de M échantillons temporels x[n] du signal d'entrée : il s'agit par exemple du cas MP correspondant à l'équation [Math.11] et lorsque les élévations à la puissance (qui restent interprétées comme des calculs de multiplications) sont implémentées dans le domaine de Walsh sous forme d'auto-convolutions dyadiques d'éléments de la série transformée, l'ordre des auto-convolutions dyadiques correspondant à l'élévation à la puissance considérée.

Quel que soit le mode de réalisation considéré, l'application d'une transformation de Walsh à une série donnée de M termes fonction d'au moins une série de M échantillons temporels x[n] du signal d'entrée délivre M composantes séquentielles d'une série transformée correspondante.

### 2. Etape E310 :

Lors d'une **étape E310,** pour au moins une composante séquentielle donnée du domaine de Walsh, un calcul est effectué d'au moins une somme d'une pluralité d'opérandes résultant du produit entre, d'une part, une donnée fonction d'au moins un élément, correspondant à la composante séquentielle donnée, d'une série transformée **X** et, d'autre part, un coefficient H de pré-distorsion correspondant délivrant une composante séquentielle $Y_{t,n}$ d'un signal d'entrée transformé pré-distordu.

Plus particulièrement, en référence aux équations [Math.8] et [Math.9], il apparait que de tels opérandes sommés résultent de la pondération par un coefficient h, élément de la matrice **H,** d'une donnée fonction :

- d'un seul élément d'une série transformée **X** : il s'agit du cas où les multiplications (ou élévations à la puissance qui restent interprétées comme des calculs de multiplications) sont implémentées dans le domaine temporel avant transformée de Walsh de la série en question ;
- d'une (ou plusieurs) convolution dyadique entre deux éléments, correspondant à la composante séquentielle donnée, appartenant chacun à une série transformée **X** : il s'agit par exemple du cas général correspondant à l'équation [Math.5] lorsque tout ou partie les multiplications sont implémentées dans le domaine temporel avant transformée de Walsh des séries en question, les autres multiplications étant implémentées dans le domaine de Walsh sous forme de convolutions dyadiques d'éléments de certaines séries transformées ; et/ou

- d'une (ou plusieurs) auto-convolution dyadique d'un élément, correspondant à la composante séquentielle donnée, d'une série transformée **X** : il s'agit par exemple du cas MP correspondant à l'équation [Math.11] et lorsque tout ou partie des élévations à la puissance (qui restent interprétées comme des calculs de multiplications) sont implémentées dans le domaine de Walsh sous forme d'auto-convolutions dyadiques. Par exemple, dans un cas optimisé en ce qui concerne la charge de calculs associée à un modèle MP, ladite somme est une somme de M opérandes. Le i-ème opérande, i un entier de 1 à M, résulte du produit entre, d'une part, une auto-convolution dyadique d'ordre i d'un élément, correspondant à la composante séquentielle donnée, de la série transformée **X** et, d'autre part, le coefficient de pré-distorsion correspondant. Ainsi, seules des auto-convolutions dyadiques sont mises en œuvre, réduisant par là-même la charge de calcul.

De retour à l'étape E310, ledit calcul répété pour les M composantes séquentielles du domaine de Walsh délivrant les M composantes séquentielles $Y_{t,n}$, $n$ un entier de 0 à M-1, du signal d'entrée transformé pré-distordu comme indiqué par les équations [Math.8] et [Math.9].

### 3. Etape E320 :

Lors d'une **étape E320,** une transformation de Walsh inverse est appliquée aux M composantes séquentielles $Y_{t,n}$ du signal d'entrée transformé pré-distordu délivrant le signal de sortie $y_t[n]$ pour la génération du signal radiofréquences. En d'autres termes, le signal radiofréquences est généré à partir du signal de sortie $y_t[n]$, lui-même fonction du signal d'entrée x[n].

Comme discuté ci-dessus en relation avec la [Fig.2], suivant le mode de réalisation considéré, le bloc 210 de pré-distorsion traite un signal d'entrée qui peut être en bande de base, en fréquence intermédiaire ou directement sur la porteuse radiofréquences d'intérêt. Dans ce dernier cas, le signal de sortie $y_t[n]$ généré à l'étape E320 est directement le signal radiofréquences (mode de réalisation illustré sur la [Fig.2]). Dans les modes de réalisation dans lesquels le signal d'entrée est en bande de base ou en fréquence intermédiaire, le signal radiofréquences est généré à partir du signal de sortie $y_t[n]$ via une transposition en fréquences comme discuté ci-dessus.

Par ailleurs, selon les modes de réalisation considérés, la transformation de Walsh inverse est implémentée de manière purement digitale (mode de réalisation illustré sur la [Fig.2]), ou bien il est tiré parti de la nature binaire des séquences de Walsh afin d'implémenter la transformée de Walsh inverse de manière semi-analogique comme discuté ci-dessus en relation avec la [Fig.2].

### 4. Etape E330 :

Les coefficients de pré-distorsion **H** mis en œuvre lors de l'étape E310 sont déterminés afin de compenser l'effet de la fonction de transfert du PA 160. Par exemple une calibration du PA 160 est effectuée en production et un (ou plusieurs, e.g. en fonction de la température ou du vieillissement du composant) jeu de coefficients de pré-distorsion **H** est ainsi déterminé.

Alternativement, les coefficients de pré-distorsion **H** sont déterminés par le bloc 210 de pré-distorsion via la boucle de rétroaction illustré sur la [Fig.2]. Une telle détermination est effectuée par exemple à l'initialisation de l'émetteur 200, ou périodiquement pendant la transmission afin de prendre en compte la variation des caractéristiques de l'amplificateur de puissance pendant la transmission du signal radiofréquences.

Plus particulièrement, trois variantes différentes sont décrites ci-dessous pour la détermination des coefficients de pré-distorsion **H** par le bloc 210 de pré-distorsion.

#### 4.1 Variante 1 :

Dans cette première variante, suivant l'architecture de l'émetteur 200 de la [Fig.2], la détermination des coefficients de pré-distorsion **H** est effectuée sur la base d'une minimisation d'un signal d'erreur représentatif d'un écart entre :

- le signal d'entrée $x[n]$ ; et
- le signal $y[n]$ représentatif de la modulation du signal radiofréquences amplifié.

En d'autres termes, on cherche ici à minimiser l'écart entre la modulation du signal radiofréquences amplifié, i.e. ayant subi la distorsion du PA 160, et le signal d'entrée véhiculant la modulation non-distordue.

Suivant les modes de réalisation, une telle minimisation met en œuvre une technique appartenant au groupe comprenant :

- Moindres carrés ;
- Moindres carrés normalisés ;
- Algorithme de Gauss-Newton ; ou
- Moindres carrés récursifs.

Avantageusement, une telle technique de minimisation est implémentée dans le domaine de Walsh sur la base des signaux constituant le signal d'erreur transposés dans le domaine de Walsh. Dans le cas présent, le signal d'erreur dans le domaine de Walsh prend la forme :

[Math.16]

$$\mathbf{E}_n = \mathbf{X}_n - \mathbf{Y}_n$$

Par exemple, l'application d'un algorithme de moindres carrés tel que détaillé dans l'ouvrage de N. Wiener, « Nonlinear Problems in Random Theory, » Cambridge, LA: MIT Press, 1958, conduit à l'équation de mise à jour des coefficients de pré-distorsion suivante :

[Math.17]

$$\mathbf{H}_{n+1} = \mathbf{H}_n + 2\mu.\mathbf{E}_n.\mathbf{X}_n$$

avec, $\mu$ le pas d'adaptation et, dans le cas d'une série de Volterra générale :

[Math.18]

$$\mathbf{X}_n = \begin{bmatrix} \mathbf{X}_{1,n} & \cdots & \mathbf{X}_{m_1 m_2 \cdots m_q, n} & \cdots & \mathbf{X}_{m_1 m_2 \cdots m_Q, n} \end{bmatrix}$$

et :

[Math.19]

$$\mathbf{H}_n = \begin{bmatrix} \mathbf{H}_{1,n} & \cdots & \mathbf{H}_{m_1 m_2 \cdots m_q, n} & \cdots & \mathbf{H}_{m_1 m_2 \cdots m_Q, n} \end{bmatrix}$$

Chaque coefficient de H est mis à jour une fois pour chaque nouveau bloc de données X (par exemple fourni à un taux de rafraîchissement prédéfini). Le gradient d'estimation est calculé comme une moyenne des données au lieu de sa valeur instantanée comme dans l'approche du domaine temporel. Par conséquent, il s'agit d'une représentation plus précise du vrai gradient et conduit à une convergence plus rapide de l'algorithme. Pour N1 itérations, N1 × M points de données sont nécessaires. Par exemple, dans le cas du modèle MP, chaque itération nécessite Q + 1 transformées de Walsh (i.e. M × log2(M) additions et/ou soustractions dans le cas d'une implémentation dite « rapide » de la transformée de Walsh), (Q × M) multiplications et/ou additions pour l'adaptation du modèle et (Q × M) multiplications et/ou additions pour la mise à jour des coefficients. Ainsi, la complexité de calcul de l'algorithme est O(2 × N1 × Q × M + (Q + 1) × M × log2(M)).

#### 4.2 Variante 2 :

Dans cette deuxième variante, la détermination des coefficients de pré-distorsion H est effectuée sur la base d'une minimisation d'un signal d'erreur représentatif d'un écart entre :

- le signal d'entrée x[n] ; et
- un deuxième signal de sortie généré par application du présent procédé de pré-distorsion à un signal d'entrée égal au signal y[n] représentatif de la modulation du signal radiofréquences amplifié.

En d'autres termes, on cherche ici à obtenir directement la compensation, par le bloc 210 de pré-distorsion, de la distorsion induite par le PA 160 en fournissant à l'entrée du bloc 210 en question le signal $y[n]$ représentatif de modulation du signal radiofréquences amplifié et en comparant la sortie du bloc 210 au signal d'entrée x[n].
Suivant les modes de réalisation, une telle minimisation met en œuvre une des techniques précitées dans le cadre de la variante 1.
Avantageusement, une telle technique de minimisation est implémentée dans le domaine de Walsh sur la base des signaux constituant le signal d'erreur dans le domaine de Walsh. Dans le cas présent, le signal d'erreur dans le domaine de Walsh prend la forme :

[Math.20]

$$\mathbf{E}_n = \mathbf{X}_n - \mathbf{X}_{t,n}$$

avec $\mathbf{X}_{t,n}$ ledit deuxième signal de sortie, transposé dans le domaine de Walsh, généré par application du présent procédé de pré-distorsion à un signal d'entrée égal au signal $y[n]$ représentatif de la modulation du signal radiofréquences amplifié. Ainsi, dans le cas d'une série de Volterra générale :

[Math.21]

$$\mathbf{X}_{t,n} = \sum_{q=1}^{Q} \sum_{m_1=0}^{M-1} \sum_{m_2=0}^{M-1} \cdots \sum_{m_q=0}^{M-1} \mathbf{Y}_{m_1 m_2 \cdots m_q, n} \cdot \mathbf{H}_{m_1 m_2 \cdots m_q, n}$$

Par exemple, l'application d'un algorithme de moindres carrés tel que précité dans le cadre de la variante 1, conduit à l'équation de mise à jour des coefficients de pré-distorsion suivante :

[Math.22]

$$\mathbf{H}_{n+1} = \mathbf{H}_n + 2\mu . \mathbf{E}_n . \mathbf{Y}_n$$

Les mêmes avantages que ceux discutés dans le cadre de la variante 1 se retrouvent ici lors de la mise en œuvre de la variante 2.

#### 4.3 Variante 3 :

Dans cette troisième variante, la détermination des coefficients de pré-distorsion **H** est effectuée sur la base d'une minimisation d'un signal d'erreur représentatif d'un écart entre :

- un signal représentatif d'une modulation d'un deuxième signal radiofréquences généré à partir dudit signal d'entrée x[n] non pré-distordu et amplifié par le PA 160 ; et
- le signal de sortie $y_t[n]$.

En d'autres termes, on cherche ici à obtenir dans un premier temps des coefficients $\mathbf{H}_{PA}$ permettant de modéliser le PA 160 en faisant converger les coefficients du modèle de sorte à obtenir en sortie du bloc 210 un signal image du deuxième signal radiofréquences obtenu en sortie du PA 160. Ainsi, dans la présente variante, le signal en sortie du modèle prend la forme, dans le cas d'une série de Volterra générale :

[Math.23]

$$Y_{t,n} = \sum_{q=1}^{Q} \sum_{m_1=0}^{M-1} \sum_{m_2=0}^{M-1} \cdots \sum_{m_q=0}^{M-1} X_{m_1 m_2 \cdots m_q, n} . H_{PA, m_1 m_2 \cdots m_q, n}$$

Les coefficients de pré-distorsion H sont obtenus à partir des coefficients modélisant l'amplificateur de puissance, e.g. suivant l'approche proposée dans l'article de Yu and E. Zhu, « A comparative study of learning architecture for digital predistortion, » 2015 Asia-Pacific Microwave Conference (APMC), 2015, pp. 1-3, via l'équation :

[Math.24]

$$H = H_{PA}^{-1}$$

Suivant les modes de réalisation, la minimisation du signal d'erreur met en œuvre une des techniques précitées dans le cadre de la variante 1.

Avantageusement, une telle technique de minimisation est implémentée dans le domaine de Walsh sur la base des signaux constituant le signal d'erreur dans le domaine de Walsh. Dans le cas présent, le signal d'erreur dans le domaine de Walsh prend la forme :

[Math.25]

$$E_n = Y'_n - Y_{t,n}$$

avec $Y'_n$ ledit signal représentatif d'une modulation d'un deuxième signal radiofréquences généré à partir dudit signal d'entrée x[n] non pré-distordu et amplifié par le PA 160.

Par exemple, dans le cas d'une série de Volterra générale, l'application d'un algorithme de moindres carrés tel que précité dans le cadre de la variante 1, conduit à l'équation suivante de mise à jour des coefficients du modèle mis en œuvre dans le bloc 210 :

[Math.26]

$$H_{PA,n+1} = H_{PA,n} + 2\mu . E_n . X_n$$

Les mêmes avantages que ceux discutés dans le cadre de la variante 1 se retrouvent ici lors de la mise en œuvre de la variante 3.

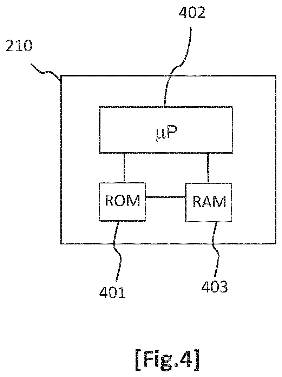

On présente désormais, en relation avec la **[Fig.4]** un exemple de structure du dispositif 210 permettant de mettre en œuvre tout ou partie des étapes du procédé de pré-distorsion de la **[Fig.3]** selon un mode de réalisation de l'invention.

Le dispositif 210 comprend différents moyens tels qu'une mémoire vive 403 (par exemple une mémoire RAM), une unité de traitement 402 équipée par exemple d'un processeur, et pilotée par un programme d'ordinateur stocké dans une mémoire morte 401 (par exemple une mémoire ROM ou un disque dur). A l'initialisation, les instructions de code du programme d'ordinateur sont par exemple chargées dans la mémoire vive 403 avant d'être exécutées par le processeur de l'unité de traitement 402.

Cette [Fig.4] illustre seulement une manière particulière, parmi plusieurs possibles, de réaliser le dispositif 210 afin qu'il effectue tout ou partie des étapes du procédé de pré-distorsion de la **[Fig.3]** (selon l'un quelconque des modes de réalisation et/ou variantes décrit(e)s ci-dessus en relation avec la [Fig.3]). En effet, ces étapes peuvent être réalisées indifféremment sur une machine de calcul reprogrammable (un ordinateur PC, un processeur DSP ou un microcontrôleur) exécutant un programme comprenant une séquence d'instructions, ou sur une machine de calcul dédiée (par exemple un ensemble de portes logiques comme un FPGA ou un ASIC, ou tout autre module matériel).

Dans le cas où le dispositif 210 est réalisé avec une machine de calcul reprogrammable, le programme correspondant (c'est-à-dire la séquence d'instructions) pourra être stocké dans un médium de stockage amovible (tel que par exemple un CD-ROM, un DVD-ROM, une clé USB) ou non, ce médium de stockage étant lisible partiellement ou totalement par un ordinateur ou un processeur.

Dans certains modes de réalisation, le dispositif 210 comprend également des moyens pour implémenter la transformation de Walsh inverse de manière semi-analogique comme discuté ci-dessus en relation avec la [Fig.2]. De tels moyens comprennent par exemple :

- une pluralité de DAC 1-bit (e.g. du type buffer), chaque DAC étant contrôlé en amplitude par la séquence de Walsh inverse correspondant à la composante séquentielle considérée pour la transformation inverse ; et
- un sommateur analogique afin de sommer les sorties des différents DAC 1-bit entre elles et générer ainsi une grandeur analogique (tension ou courant) représentative de la transformée de Walsh inverse du signal d'entrée transformé pré-distordu de sorte à générer le signal de sortie. Ainsi, dans tous les modes de réalisation, le dispositif 210 comprend des moyens configurés pour exécuter tout ou partie des étapes du procédé de pré-distorsion de la [Fig.3] (selon l'un quelconque des modes de réalisation et/ou variantes décrit(e)s ci-dessus en relation avec la [Fig.3]).

Dans certains modes de réalisation, le dispositif 210 est implémenté dans l'émetteur 200 radiofréquences.

## Revendications

**1.** Procédé de pré-distorsion d'un signal d'entrée pour compenser l'effet, sur un signal radiofréquences généré à partir du signal d'entrée, d'une fonction de transfert non-linéaire d'un amplificateur de puissance (160) configuré pour amplifier le signal radiofréquences, **caractérisé en ce qu'**un dispositif électronique effectue :

- une transformation (E300) de Walsh d'au moins une série de M termes fonction d'au moins une série de M échantillons temporels du signal d'entrée délivrant M composantes séquentielles d'au moins une série transformée correspondante ;
- pour au moins une composante séquentielle donnée du domaine de Walsh, un calcul (E310) d'au moins une somme d'une pluralité d'opérandes résultant du produit entre, d'une part, une donnée fonction d'au moins un élément, correspondant à la composante séquentielle donnée, d'une série transformée et, d'autre part, un coefficient de pré-distorsion correspondant délivrant une composante séquentielle d'un signal d'entrée transformé pré-distordu, au moins une donnée étant fonction d'au moins une convolution dyadique entre deux éléments, correspondant à la composante séquentielle donnée, appartenant chacun à une série transformée et/ou étant fonction d'au moins une auto-convolution dyadique d'un élément, correspondant à la composante séquentielle donnée, d'une série transformée,

la somme suivant une structure d'une série de Volterra, fonction d'échantillons temporels du signal d'entrée, transposée dans le domaine de Walsh,
les coefficients de pré-distorsion étant déterminés afin de compenser l'effet de la fonction de transfert de l'amplificateur de puissance,
ledit calcul répété pour les M composantes séquentielles du domaine de Walsh délivrant M composantes séquentielles du signal d'entrée transformé pré-distordu,

- une transformation (E320) de Walsh inverse des M composantes séquentielles du signal d'entrée transformé pré-distordu délivrant un signal de sortie pour la génération du signal radiofréquences.

**2.** Procédé selon la revendication 1, dans lequel ladite transformation de Walsh est appliquée à une pluralité de séries de M termes fonction d'au moins une série de M échantillons temporels du signal d'entrée délivrant M composantes séquentielles d'une pluralité de séries transformées correspondantes,

et dans lequel ladite au moins une donnée est fonction :

- d'au moins une convolution dyadique entre deux éléments, correspondant à la composante séquentielle donnée, appartenant chacun à une série transformée de la pluralité de séries transformées ; et/ou
- d'au moins une auto-convolution dyadique d'un élément, correspondant à la composante séquentielle donnée, d'une série transformée de la pluralité de séries transformées,

et dans lequel la somme suit une structure d'une série de Volterra, fonction de ladite pluralité de séries de M échantillons temporels du signal d'entrée, transposée dans le domaine de Walsh.

**3.** Procédé selon la revendication 2, dans lequel au moins une série de M termes comprend au moins un terme fonction :

- du produit entre deux échantillons temporels du signal d'entrée ; et/ou
- d'au moins un échantillon temporel du signal d'entrée élevé à une puissance entière.

**4.** Procédé selon la revendication 1, dans lequel ladite transformation de Walsh est appliquée à une pluralité de séries de M termes fonction d'une série de M échantillons temporels du signal d'entrée délivrant M composantes séquentielles d'une pluralité de séries transformées correspondantes,
et dans lequel ladite au moins une donnée est fonction d'au moins une auto-convolution dyadique d'un élément, correspondant à la composante séquentielle donnée, d'une série transformée de la pluralité de séries transformées.

**5.** Procédé selon la revendication 4, dans lequel au moins une série de M termes comprend au moins un terme fonction d'au moins un échantillon temporel du signal d'entrée élevé à une puissance entière.

**6.** Procédé selon la revendication 1, dans lequel ladite transformation de Walsh est appliquée à une série de M termes correspondant à une série donnée de M échantillons temporels du signal d'entrée délivrant M composantes séquentielles d'une série transformée correspondante,
et dans lequel ledit calcul comprend le calcul d'une somme de M opérandes, le i-ème opérande, i un entier de 1 à M, résultant du produit entre, d'une part, une donnée résultant d'une auto-convolution dyadique d'ordre i d'un élément, correspondant à la composante séquentielle donnée, de la série transformée et, d'autre part, le coefficient de pré-distorsion correspondant.

**7.** Procédé selon l'une quelconque des revendications 1 à 6, comprenant une détermination des coefficients de pré-distorsion sur la base d'une minimisation d'un signal d'erreur représentatif d'un écart entre, d'une part, ledit signal d'entrée et, d'autre part, un signal représentatif d'une modulation dudit signal radiofréquences amplifié.

**8.** Procédé selon l'une quelconque des revendications 1 à 6, comprenant une détermination des coefficients de pré-distorsion sur la base d'une minimisation d'un signal d'erreur représentatif d'un écart entre, d'une part, ledit signal d'entrée et, d'autre part, un deuxième signal de sortie généré par application dudit procédé à un signal d'entrée représentatif d'une modulation dudit signal radiofréquences amplifié.

**9.** Procédé selon l'une quelconque des revendications 1 à 6, comprenant une détermination des coefficients de pré-distorsion sur la base d'une minimisation d'un signal d'erreur représentatif d'un écart entre, d'une part, un signal représentatif d'une modulation d'un deuxième signal radiofréquences généré à partir dudit signal d'entrée non pré-distordu et amplifié par l'amplificateur de puissance et, d'autre part, ledit signal de sortie.

**10.** Procédé selon l'une quelconque des revendications 7 à 9, dans lequel ladite détermination met en œuvre, pour ladite minimisation, une technique appartenant au groupe comprenant :

- Moindres carrés ;
- Moindres carrés normalisés ;
- Algorithme de Gauss-Newton ; ou
- Moindres carrés récursifs.

**11.** Procédé selon la revendication 10, dans lequel ladite technique est implémentée dans le domaine de Walsh sur la base des signaux constituant le signal d'erreur transposés dans le domaine de Walsh.

**12.** Procédé selon l'une quelconque des revendications 7 à 11, dans lequel ladite détermination est effectuée périodiquement.

**13.** Produit programme d'ordinateur comprenant des instructions de code de programme pour la mise en œuvre du procédé selon l'une quelconque des revendications 1 à 12, lorsque ledit programme est exécuté sur un ordinateur.

**14.** Dispositif (210) électronique de pré-distorsion d'un signal d'entrée pour compenser l'effet, sur un signal radiofréquences généré à partir du signal d'entrée, d'une fonction de transfert non-linéaire d'un amplificateur de puissance (160) configuré pour amplifier le signal radiofréquences,
**caractérisé en ce qu'**il comprend des moyens (402) configurés pour la mise en œuvre d'un procédé de pré-distorsion selon l'une quelconque des revendications 1 à 12.

**15.** Emetteur (200) radiofréquences comprenant un dispositif selon la revendication 14.

**Patentansprüche**

**1.** Verfahren zur Vorverzerrung eines Eingangssignals zum Kompensieren der Auswirkung einer nichtlinearen Übertragungsfunktion eines Leistungsverstärkers (160), der zum Verstärken des Funkfrequenzsignals eingerichtet ist, auf ein aus dem Eingangssignal erzeugtes Funkfrequenzsignal, **dadurch gekennzeichnet, dass** eine elektronische Vorrichtung Folgendes durchführt:

- eine Walsh-Transformation (E300) von mindestens einer Reihe von M Begriffen in Abhängigkeit von mindestens einer Reihe von M Zeitabtastwerten des Eingangssignals, die M sequenzielle Komponenten von mindestens einer entsprechenden transformierten Reihe liefern;
- für mindestens eine bestimmte sequenzielle Komponente der Walsh-Domäne eine Berechnung (E310) von mindestens einer Summe einer Vielzahl von aus dem Produkt resultierenden Operanden zwischen einerseits einer bestimmten Funktion von mindestens einem Element, entsprechend der gegebenen sequenziellen Komponente einer transformierten Reihe und andererseits einem entsprechenden Vorverzerrungskoeffizienten,

der eine sequenzielle Komponente eines vorverzerrten transformierten Eingangssignals liefert, wobei mindestens eine Angabe eine Funktion von mindestens einer dyadischen Konvolution zwischen zwei Elementen, die der gegebenen sequenziellen Komponente entsprechen und jeweils zu einer transformierten Reihe gehören, und/oder eine Funktion von mindestens einer dyadischen Autokonvolution eines Elements ist, das der gegebenen sequenziellen Komponente einer transformierten Reihe entspricht, wobei die Summe einer Struktur einer Volterra-Reihe folgt, die eine Funktion von Zeitabtastwerten des Eingangssignals ist, transponiert in die Walsh-Domäne, wobei die Vorverzerrungskoeffizienten bestimmt werden, um den Effekt der Übertragungsfunktion des Leistungsverstärkers zu kompensieren, die wiederholte Berechnung für die M sequenziellen Komponenten der Walsh-Domäne, die M sequenzielle Komponenten des vorverzerrten transformierten Eingangssignals liefern,

- eine umgekehrte Walsh-Transformation (E320) der sequenziellen M Komponenten des vorverzerrten transformierten Eingangssignals, die ein Ausgangssignal zur Erzeugung des Funkfrequenzsignals liefern.

**2.** Verfahren nach Anspruch 1, wobei die Walsh-Transformation auf eine Vielzahl von Reihen von M Begriffen in Abhängigkeit von mindestens einer Reihe von M Zeitabtastwerten des Eingangssignals angewendet wird, die M sequenzielle Komponenten einer Vielzahl von entsprechenden transformierten Reihen liefern,

und wobei die mindestens eine Angabe eine Funktion ist:

- mindestens einer dyadischen Konvolution zwischen zwei Elementen, die der gegebenen sequenziellen Komponente entsprechen und jeweils zu einer transformierten Reihe der Vielzahl von transformierten Reihen gehören; und/oder
- mindestens einer dyadischen Autokonvolution eines Elements, das der gegebenen sequenziellen Komponente entspricht, einer transformierten Reihe der Vielzahl von transformierten Reihen,

und wobei die Summe einer Struktur einer Volterra-Reihe folgt, die eine Funktion von der Vielzahl von Reihen von M Zeitabtastwerten des Eingangssignals ist, transponiert in die Walsh-Domäne.

**3.** Verfahren nach Anspruch 2, wobei mindestens eine Reihe von M Begriffen mindestens einen Funktionsbegriff von Folgendem umfasst:

- des Produkts zwischen zwei Zeitabtastwerten des Eingangssignals; und/oder
- von mindestens einem Zeitabtastwert des Eingangssignals, das auf eine ganze Potenz erhöht ist.

**4.** Verfahren nach Anspruch 1, wobei die Walsh-Transformation auf eine Vielzahl von Reihen von M Begriffen in Abhängigkeit von einer Reihe von M Zeitabtastwerten des Eingangssignals angewendet wird, die M sequenzielle Komponenten einer Vielzahl von entsprechenden transformierten Reihen liefern, und wobei die mindestens eine Angabe von mindestens einer dyadischen Autokonvolution eines Elements, das der gegebenen sequenziellen Komponente entspricht, einer transformierten Reihe der Vielzahl von transformierten Reihen abhängt.

5. Verfahren nach Anspruch 4, wobei mindestens eine Reihe von M Begriffen mindestens einen Begriff umfasst, der von mindestens einem Zeitabtastwert des hohen Eingangssignals bei voller Leistung abhängt.

6. Verfahren nach Anspruch 1, wobei die Walsh-Transformation auf eine Reihe von M Begriffen angewendet wird, die einer bestimmten Reihe von M Zeitabtastwerten des Eingangssignals entsprechen, die M sequenzielle Komponenten einer entsprechenden transformierten Reihe liefern,

und wobei die Berechnung die Berechnung einer Summe von M Operanden umfasst, wobei der i-te Operand, i eine ganze Zahl von 1 bis M, aus dem Produkt zwischen einerseits einer Angabe, die aus einer dyadischen Autokonvolution der Ordnung i eines Elements resultiert, das der gegebenen sequenziellen Komponente der transformierten Reihe entspricht, und andererseits dem entsprechenden Vorverzerrungskoeffizienten resultiert.

7. Verfahren nach einem der Ansprüche 1 bis 6, umfassend eine Bestimmung der Vorverzerrungskoeffizienten auf der Grundlage einer Minimierung eines Fehlersignals, das für eine Abweichung zwischen einerseits dem Eingangssignal und andererseits einem Signal repräsentativ ist, das für eine Modulation des verstärkten Hochfrequenzsignals repräsentativ ist.

8. Verfahren nach einem der Ansprüche 1 bis 6, umfassend eine Bestimmung der Vorverzerrungskoeffizienten auf der Grundlage einer Minimierung eines Fehlersignals, das für eine Abweichung zwischen dem Eingangssignal einerseits und einem zweiten Ausgangssignal repräsentativ ist, das durch Anwendung des Verfahrens auf ein Eingangssignal erzeugt wird, das für eine Modulation des verstärkten Funkfrequenzsignals repräsentativ ist.

9. Verfahren nach einem der Ansprüche 1 bis 6, umfassend eine Bestimmung der Vorverzerrungskoeffizienten auf der Grundlage einer Minimierung eines Fehlersignals, das für eine Abweichung zwischen einerseits einem Signal, das für eine Modulation eines zweiten Funkfrequenzsignals repräsentativ ist, das aus dem nicht vorverzerrten Eingangssignal erzeugt und von dem Leistungsverstärker verstärkt wird, und andererseits dem Ausgangssignal repräsentativ ist.

10. Verfahren nach einem der Ansprüche 7 bis 9, wobei die Bestimmung, für die Minimierung, eine Technik der Gruppe bereitstellt, die zu der Gruppe gehört, die Folgendes umfasst:

   - kleinste Quadrate;
   - normierte kleinste Quadrate;
   - Gauß-Newton-Algorithmus; oder
   - rekursive kleinste Quadrate.

11. Verfahren nach Anspruch 10, wobei die Technik in der Walsh-Domäne auf der Grundlage der das Fehlersignal bildenden Signale implementiert wird, die in die Walsh-Domäne transponiert sind.

12. Verfahren nach einem der Ansprüche 7 bis 11, wobei die Bestimmung periodisch erfolgt.

13. Computerprogrammprodukt, das Programmcodeanweisungen für die Bereitstellung des Verfahrens nach einem der Ansprüche 1 bis 12 umfasst, wenn das Programm auf einem Computer ausgeführt wird.

14. Elektronische Vorverzerrungsvorrichtung (210) für ein Eingangssignal, um die Auswirkung einer nichtlinearen Übertragungsfunktion eines Leistungsverstärkers (160), der zur Verstärkung des Funkfrequenzsignals eingerichtet ist, auf ein aus dem Eingangssignal erzeugtes Funkfrequenzsignal zu kompensieren,
**dadurch gekennzeichnet, dass** es Mittel (402) umfasst, die für die Bereitstellung eines Vorverzerrungsverfahrens nach einem der Ansprüche 1 bis 12 eingerichtet sind.

15. Funksender (200), der eine Vorrichtung nach Anspruch 14 umfasst.

**Claims**

1. Method for predistorting an input signal to compensate for the effect, on a radiofrequency signal generated from the input signal, of a non-linear transfer function of a power amplifier (160) configured to amplify the radiofrequency signal, **characterized in that** an electronic device performs:

- a Walsh transform (E300) of at least one series of M terms dependent on at least one series of M temporal samples of the input signal delivering M sequential components of at least one corresponding transformed series;
- for at least one given sequential component of the Walsh domain, calculating (E310) at least one sum of a plurality of operands resulting from the product between, on the one hand, a piece of data dependent on at least one element, corresponding to the given sequential component, of a transformed series and, on the other hand, a corresponding predistortion coefficient

delivering a sequential component of a predistorted transformed input signal, at least one piece of data being dependent on at least one dyadic convolution between two elements, corresponding to the given sequential component, each belonging to a transformed series and/or being dependent on at least one dyadic self-convolution of an element, corresponding to the given sequential component, of a transformed series, the sum following a structure of a Volterra series, dependent on temporal samples of the input signal, transposed into the Walsh domain, the predistortion coefficients being determined in order to compensate for the effect of the transfer function of the power amplifier, said repeated calculation for the M sequential components of the Walsh domain delivering M sequential components of the predistorted transformed input signal,

- an inverse Walsh transform (E320) of the M sequential components of the predistorted transformed input signal delivering an output signal for the generation of the radiofrequency signal.

2. Method according to claim 1, wherein said Walsh transform is applied to a plurality of series of M terms dependent on at least one series of M temporal samples of the input signal delivering M sequential components of a plurality of corresponding transformed series, and wherein said at least one piece of data depends on:

- at least one dyadic convolution between two elements, corresponding to the given sequential component, each belonging to a transformed series of the plurality of transformed series; and/or
- at least one dyadic self-convolution of an element, corresponding to the given sequential component, of a transformed series of the plurality of transformed series, and wherein the sum follows a structure of a Volterra series, dependent on said plurality of series of M temporal samples of the input signal, transposed into the Walsh domain.

3. Method according to claim 2, wherein at least one series of M terms comprises at least one term dependent on:

- the product between two temporal samples of the input signal; and/or
- at least one temporal sample of the input signal raised to an integer power.

4. Method according to claim 1, wherein said Walsh transform is applied to a plurality of series of M terms dependent on a series of M temporal samples of the input signal delivering M sequential components of a plurality of corresponding transformed series, and wherein said at least one piece of data depends on at least one dyadic self-convolution of an element, corresponding to the given sequential component, of a transformed series of the plurality of transformed series.

5. Method according to claim 4, wherein at least one series of M terms comprises at least one term dependent on at least one temporal sample of the input signal raised to an integer power.

6. Method according to claim 1, wherein said Walsh transform is applied to a series of M terms corresponding to a given series of M temporal samples of the input signal delivering M sequential components of a corresponding transformed series, and wherein said calculation comprises calculating a sum of M operands, the i-th operand, i an integer from 1 to M, resulting from the product between, on the one hand, a piece of data resulting from a i-order dyadic self-convolution of an element, corresponding to the given sequential component, of the transformed series and, on the other hand, the corresponding predistortion coefficient.

7.  Method according to any one of claims 1 to 6, comprising determining the predistortion coefficients based on a minimization of an error signal representative of a discrepancy between, on the one hand, said input signal and, on the other hand, a signal representative of a modulation of said amplified radiofrequency signal.

8.  Method according to any one of claims 1 to 6, comprising determining the predistortion coefficients based on a minimization of an error signal representative of a discrepancy between, on the one hand, said input signal and, on the other hand, a second output signal generated by application of said method to an input signal representative of a modulation of said amplified radiofrequency signal.

9.  Method according to any one of claims 1 to 6, comprising determining the predistortion coefficients based on a minimization of an error signal representative of a discrepancy between, on the one hand, a signal representative of a modulation of a second radiofrequency signal generated from said non-predistorted input signal and amplified by the power amplifier and, on the other hand, said output signal.

10. Method according to any one of claims 7 to 9, wherein said determination implements, for said minimization, a technique belonging to the group comprising:

    - least squares;
    - normalized least squares;
    - Gauss-Newton algorithm; or
    - recursive least squares.

11. Method according to claim 10, wherein said technique is implemented in the Walsh domain based on the signals making up the transposed error signal in the Walsh domain.

12. Method according to any one of claims 7 to 11, wherein said determination is performed periodically.

13. Computer program product comprising program code instructions for implementing the method according to any one of claims 1 to 12, when said program is executed on a computer.

14. Electronic device (210) for predistorting an input signal to compensate for the effect, on a radiofrequency signal generated from the input signal, of a non-linear transfer function of a power amplifier (160) configured to amplify the radiofrequency signal,
    **characterized in that** it comprises means (402) configured to implement a predistortion method according to any one of claims 1 to 12.

15. Radiofrequency emitter (200) comprising a device according to claim 14.

[Fig.1]

[Fig.1a]

[Fig.1b]

[Fig.1c]

[Fig.2]

[Fig.3]

[Fig.4]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 10075201 B1

**Littérature non-brevet citée dans la description**

- **A. KATZ** ; **J. WOOD** ; **D. CHOKOLA**. The evolution of pa linearization: From classic feedforward and feedback through analog and digital predistortion. *IEEE Microwave Magazine*, 2016, vol. 17 (2), 32-40
- **J. JOHNSON** ; **M. PUSCHEL**. In search of the optimal walsh-hadamard transform. *2000 IEEE International Conference on Acoustics, Speech, and Signal Processing. Proceedings*, 2000, vol. 6, 3347-3350
- **M. Z. ANNA USAKOVA** ; **JANA KOTULIAKOVA**. Journal of electrical engineering. MIT Press, 1958, vol. 53, 285-288
- **N. WIENER**. Nonlinear Problems in Random Theory. MIT Press, 1958
- **YU** ; **E. ZHU**. A comparative study of learning architecture for digital predistortion. *2015 Asia-Pacific Microwave Conference (APMC)*, 2015, 1-3